Europäisches Patentamt

(19) European Patent Office

Office européen des brevets

(11) Numéro de publication: **0 022 001**

**A1**

(12)

# DEMANDE DE BREVET EUROPEEN

(21) Numéro de dépôt: **80400907.4**

(22) Date de dépôt: **19.06.80**

(51) Int. Cl.³: **H 01 L 29/78**
**H 01 L 29/60, H 01 L 29/10**

(30) Priorité: **29.06.79 FR 7916902**

(43) Date de publication de la demande:
**07.01.81 Bulletin 81/1**

(84) Etats Contractants Désignés:
**CH DE GB IT LI NL SE**

(71) Demandeur: **"THOMSON-CSF"**
**173, Boulevard Haussmann**
**F-75360 Paris Cedex 08(FR)**

(72) Inventeur: **Tonnel, Eugène**
**"THOMSON-CSF" SCPI 173, bld Haussmann**
**F-75360 Paris Cedex 08(FR)**

(74) Mandataire: **Favre, Maurice et al,**
**"THOMSON-CSF" - SCPI 173, bld Haussmann**
**F-75360 Paris Cedex 08(FR)**

(54) Transistor à effet de champ vertical de puissance pour hautes fréquences, et procédé de réalisation d'un tel transistor.

(57) L'invention concerne les transistors à effet de champ de type vertical.

Lorsque de grands courants y sont recherchés, les électrodes de source $(S_1)$ $(S_2)$ ne peuvent augmenter leur surface de contact, car dans les transistors de structure connue, un risque de court-circuit avec l'électrode de grille (g), située dans le même plan qu'elles, serait à craindre. Selon l'invention, on dispose les électrodes de source (31) et de grille (G) suivant deux plans superposés, avec interposition d'une couche isolante (30) d'oxyde de silicium.

Les applications sont notamment la réalisation de transistors de puissance pour les hautes fréquences.

FIG.2

EP 0 022 001 A1

1

TRANSISTOR A EFFET DE CHAMP VERTICAL DE PUISSANCE POUR
HAUTES FREQUENCES, ET PROCEDE DE REALISATION D'UN TEL
TRANSISTOR.

La présente invention se rapporte au domaine des dispositifs à semi-conducteurs connus sous le nom de transistors, dans la catégorie destinée à une utilisation, pour l'amplification ou la commutation, dans la gamme des puissances comprises entre quelques watts et une centaine de watts, et à des fréquences comprises entre quelques mégahertz et un gigahertz.

Les transistors de type bipolaire ont été, malgré leurs limitations, pratiquement les seuls utilisables jusqu'à une époque récente, pour satisfaire à ces caractéristiques simultanées, jusqu'à l'apparition des transistors du type à effet de champ à grille isolée à structure dite "verticale", où ces derniers peuvent apporter des avantages dans le domaine de la tenue en tension, de la linéarité, de la rapidité en commutation et de la stabilité.

Sous la forme de réalisation où la région de formation du canal est diffusée, et suivant une structure verticale décrite par exemple dans le brevet des Etats-Unis n° 4.055.884, analysée plus loin en détail, il a été possible de vérifier l'obtension de certains des avantages caractéristiques des transistors à effet de champ énumérés plus haut. Cependant, l'accession vers les puissances élevées se trouve limitée dans ce cas, toute augmentation des dimensions en vue de présenter à la fois des régions conductrices de plus grande section et une meilleure dissipation thermique se traduisant par l'introduction de parcours de plus grande longueur augmentant la résistance série opposée au courant et un abaissement de la vitesse de commutation.

2

Il n'est donc pas possible d'augmenter les dimensions de tels transistors, au moins dans la direction définie, sur une coupe, par le plan contenant les lignes de courant source-drain.

Une solution au problème réside dans le branchement en parallèle d'une pluralité de transistors à effet de champ de dimensions habituelles, structure sauvegardant toutes les caractéristiques de fonctionnement recherchées énumérées plus haut, et procurant de plus celle de la puissance élevée.

Cependant, une telle solution risque de susciter un nouveau problème, celui de l'encombrement total du dispositif semi-conducteur obtenu, et conduit, suivant des réalisations connues, à la nécessité de prévoir une réduction notable des dimensions occupées sur la face du substrat semi-conducteur, ou "face avant" par les éléments de contact avec les électrodes de chaque transistor unitaire, à savoir source, région de formation de canal et grille.

Or les modes de réalisation habituels connus dans l'état de la technique, comportent une disposition où ces différents éléments de contact sont présents dans une même couche, ou "coplanaires", et sur la face avant du substrat ; la définition précise de leur position devient alors extrêmement difficile en fabrication lorsque les surfaces disponibles pour eux sur cette face diminuent.

C'est un but de la présente invention que de proposer une structure de transistor à effet de champ à grille isolée à structure verticale se prêtant bien à une réduction des dimensions, dont une caracté-

3

ristique est l'adoption d'une grille en matériau à haute résistance aux températures élevées, tel que le silicium polycristallin ; il est également proposé un procédé permettant la réalisation d'un tel transistor, comportant une suite d'étapes assurant l'auto-positionnement des régions de source et de formation de canal par rapport à la grille.

L'intérêt fondamental qui s'attache dans ce cas à l'adoption d'une grille en matériau réfractaire est que sa fonction de positionnement des régions sera assumée tout au long du procédé, et pendant tous les traitements thermiques, dont certains à haute température, tandis que les masques des procédés habituels, à résines photo-sensibles, seraient totalement détruits.

Un autre problème est lié à la conception d'un transistor de puissance, celui des zones de contact électrique avec les régions traversées par le courant contrôlé, qui doivent présenter une résistance ohmique aussi faible que possible.

Dans le cas des transistors à effet de champ à structure verticale, c'est la source, située sur la face avant, qui constitue la région critique, le drain, situé sur la face arrière, se prêtant bien à un recouvrement par une couche métallique de contact épaisse sur toute sa surface. Il faut donc donner au contact de source une surface maximale, tendant verscelle qui est occupée par la totalité du transistor sur le substrat.

C'est un autre but de l'invention que de proposer une disposition des contacts sur les régions de source, de formation de canal et de grille non plus "coplanaire",

4

comme dans l'art connu, mais au contraire étagée, la grille étant située sous l'élément de contact de source, et l'élément de contact de grille étant réalisé latéralement, en dehors de la surface couverte par celui de la source.

Une telle prise de contact de chaque source permet de connecter électriquement en parallèle toutes les sources de la pluralité des transistors, par une plaque métallique de contact unique, procurant un contact d'ensemble à très faible résistance.

Un autre problème est encore présent dans le domaine des transistors de puissance, celui de l'évacuation de l'énergie calorifique. Celle qui se dégage sur la face arrière est aisée à dissiper par montage sur un support convenable. En revanche, celle de la face avant est difficile à évacuer, dans les transistors de type connu, en raison de la surface limitée disponible pour la zone de la source, par suite de la présence de la zone de grille et des gardes d'isolement indispensables.

C'est encore un autre but de l'invention que d'apporter une solution à ce problème, en proposant un transistor à effet de champ à grille isolée de structure verticale se prêtant à la mise en place sur la face avant d'une plaque dissipatrice plane conductrice de la chaleur, en liaison thermique avec la zone de source du transistor.

C'est enfin un autre but de l'invention que de proposer un mode de mise en oeuvre du transistor défini ci-dessus, sous la forme d'une mise en parallèle d'une pluralité de tels transistors, réalisés dans un substrat semi-conducteur unique, et procurant un transistor unique "multi-éléments" de grande puissance, et doté simultanément des caractéristiques avantageuses propres aux transistors à effet de champ à structure verticale indiquées plus haut.

Il est à remarquer que l'augmentation du courant admissible dans le transistor, obtenue par la mise en parallèle d'une pluralité de transistorsélémentaires, peut être également complétée par un allongement de ceux-ci dans une direction perpendiculaire à celle de la mise en parallèle.

Le transistor unique multiéléments obtenu apparaît alors comme résultant de la création dans un substrat plan, suivant deux axes perpendiculaires, d'une pluralité de transistors unitaires, mis en parallèle suivant une direction, et étendus parallèlement à eux-mêmes suivant l'autre.

Plus précisément, l'invention se rapporte à un transistor à effet de cham vertical de puissance pour haute fréquences, comprenant, dans un substrat de silicium de type de conductivité N, avec deux faces principales respectivement avant et arrière, une région de drain de type de conductivité N + débouchant sur la face arrière, deux régions de source, de type de conductivité N +, respectivement incluses dans deux régions de formation de canal, de type de conductivité P, débouchant sur la face avant, cette face étant recouverte d'une couche d'oxyde de silicium, et une grille de silicium polycristallin, entièrement incluse dans cette couche, et disposée entre les deux régions de source,

6

transistor caractérisé en ce que les connexions reliant les deux régions de source sont constituées par une couche métallique conductrice déposée sur la couche d'oxyde de silicium.

L'invention sera mieux comprise à l'aide de la description ci-après, en s'appuyant sur les figures annexées, où :

- La figure 1 représente, suivant une vue en coupe, un transistor à effet de champ à grille isolée de type vertical selon l'art connu ;

- La figure 2 représente, suivant une vue en coupe, un transistor de même type, d'une structure conforme à l'invention ;

- La figure 3 représente, suivant une vue en coupe, un transistor multi-éléments de puissance selon l'invention réunissant en parallèle une pluralité de transistors suivant la figure 2 :

- La figure 4 représente, suivant une vue en plan, un transistor multi-éléments correspondant à la figure 3.

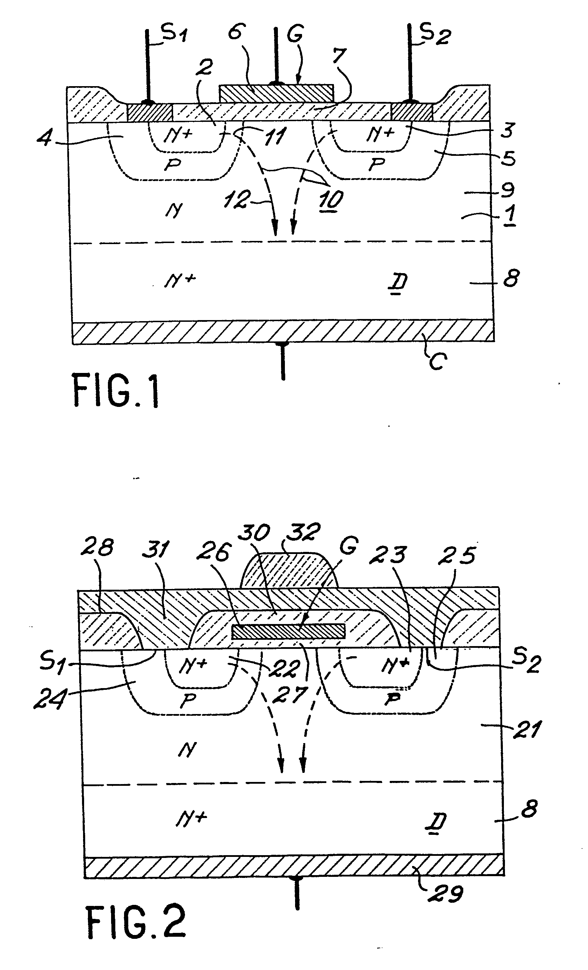

La figure 1 représente, suivant une vue en coupe, un transistor à effet de champ à grille isolée de type vertical selon l'art connu.

Il est constitué d'un substrat de silicium monocristallin 1, de type de conductivité N, et comporte deux régions de source (N+) 2 et 3, deux régions de formation de canal (P) 4 et 5, dans lesquelles le canal, de type N se forme, ainsi qu'il est connu, par le mécanisme d'inversion de charges, et une grille métallique (G) 6, isolée du substrat par une couche

7

d'oxyde de silicium 7. La région du drain (D) est constituée par une région 8 fortement dopée N + du substrat lui-même, disposée à 90° par rapport aux canaux 4 et 5. Il est précédé d'une région 9 du type N, dite "de conduction", dont l'épaisseur et la résistivité déterminent la résistance et la "tenue" en tension du transistor.

Des prises de contact $S_1$, $S_2$ et C sont respectivement réalisées, les deux premières simultanément sur les deux régions de source et de formation de canal, la troisième sur le drain D.

Une caractéristique fondamentale de ce mode de réalisation d'un transistor tient en ce que la région de formation de canal P est réalisée par diffusion, la longueur du canal, mesurée parallèlement à la face avant du substrat, étant déterminée à la fabrication par l'extension géométrique latérale des deux diffusions N + et P, c'est-à-dire, en pratique, par des temps de chauffage.

En fonctionnement, l'application des tensions électriques aux prises de contact $S_1$ $S_2$ et C détermine le déplacement des charges suivant des trajectoires telles que 10, qui comportent une première partie 11 sensiblement parallèle à la face avant du transistor et par conséquent à la grille G, et une seconde partie 12 perpendiculaire à cette face.

Le fait que les prises de contact $S_1$ et $S_2$ sont simultanées sur les sources et les régions de formation des canaux crée, sous l'influence du passage du courant, une auto-polarisation des sources par rapport aux canaux.

8

La tension appliquée à la grille G règle le passage du courant.

Une telle disposition, où les connexions de source et de grille sont dans une même couche, présente le grave inconvénient de limiter considérablement la surface de la connexion de source, inconvénient dont on a indiqué les conséquences plus haut.

De plus, les procédés de fabrication connus dans l'état de l'art pour réaliser une telle structure de transistor, mettent tous en oeuvre une succession d'étapes où la création des régions de Source et de formation de canal précède la définition de la surface de grille par gravure chimique. Le concept d'auto-alignement de ces régions par rapport à la grille, permis lorsque la grille est réalisée en premier lieu, et peut ainsi servir de masque pour les opérations suivantes, ne peut donc être exploité, ce qui entraîne l'obligation d'introduire des distances de tolérance dans leur positionnement, qui limitent encore le rapport entre la surface utile de contact de source et la surface totale de la face avant.

La figure 2 représente, suivant une vue en coupe, un transistor à effet de champ à grille isolée de type vertical selon l'invention.

Il est réalisé dans une couche épitaxiée de silicium monocristallin 21 de type de conductivité N, et comporte deux régions de source (N +) 22 et 23, deux régions de formation de canal (P) 24 et 25, et une grille (G) 26, isolée du substrat par une couche d'oxyde de silicium 27. La région du drain est constituée par le substrat lui-même (D), disposé à 90° par rapport aux canaux 24 et 25, de conductivité N +, et de la couche
épitaxiée 21.

Des connexions 28 et 29 sont respectivement
réalisées, les deux premières $S_1$ et $S_2$ simultanément
sur les deux régions de source et de formation de
canal, la troisième sur la région du drain D, constitué
par la région à haute conductibité N +.

Une différence du transistor de l'invention
par rapport à l'art connu est que la grille (G), qui
contrôle les courants issus des sources, est entièrement
recouverte d'oxyde en 30, et que le contact de grille
est pris latéralement, dans une zone de la face avant
extérieure à la zone de contact de source.

Il en résulte que les contacts de source,
et de la région de formation de canal $S_1$ et $S_2$ peuvent
être électriquement connectés ensemble par une couche
conductrice métallique épaisse 31, munie d'un bossage
de contact 32, de large surface, couche procurant par
sa structure superposée, les avantages qu'on a énumérés
plus haut, par rapport à la disposition "coplanaire"
connue à une seule couche.

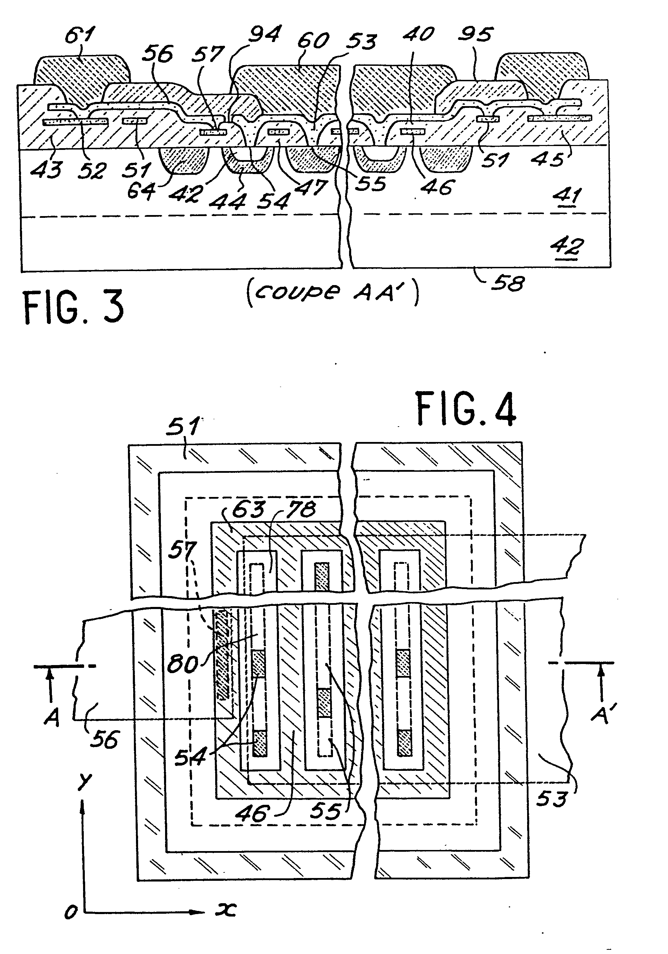

Les figures 3 et 4 représentent, suivant
respectivement une vue en coupe, et une vue en plan,
un transistor multi-éléments de puissance selon l'invention, réunissant en parallèle une pluralité de
transistors conformes à la figure 2, où les mêmes
éléments portent les mêmes références.

Les éléments multiples dont chacun est
conforme à celui de la figure 2, sont créés dans une
couche de silicium 41, de type N, épitaxié sur une région
42 fortement dopée N +, constituant la région de drain sur la face arrière. La région N, 41 représente la région dite de conduction du transistor. On trouve en 47 la couche d'oxyde mince sous chaque grille active 46, en 44 les régions de formation de canal diffusées de type P, en 42 les régions de source de type N +.

En 43 et 45, une région d'oxyde épais marginale contient un écran 51 et une contre-électrode 52, disposée en vis-à-vis des régions où seront soudés les fils de connexion avec le boîtier. La région diffusée à la périphérie de l'élément, n'est pas connectée ; elle contribue, avec l'écran 51, à réduire et à stabiliser le champ électrique en surface, et joue le rôle d'anneau de garde.

Les régions de source et de formation de canal sont connectées ensemble par la même électrode 53, par l'intermédiaire de contacts qui sont alternativement pris sur les régions de source en 54, et de formation en 55, comme il est représenté sur la vue en plan de la figure 4. Chaque grille 46 est reliée avec ses voisines par une bande latérale 63, gravée dans la même couche que les grilles, et est enrobée dans la couche d'oxyde 40. La couche conductrice de contact 53 est ainsi totalement isolée de la grille. Cette dernière est reliée avec l'extérieur par la couche de contact 56, reliée à l'extérieur, à travers la couche isolante 40, grâce à l'ouverture 57. Les contre-électrodes sont en contact respectivement avec les couches de contact 53 et 56, en vis-à-vis des ouvertures ménagées dans la couche d'oxyde 95. L'écran 51 peut être connecté soit à la couche de contact de source, comme représenté, soit à l'anneau de garde.

Le transistor multi-élément de l'invention peut être monté par sa face arrière de drain 58 sur un support-embase, de façon connue, et connecté en fixant des fils par compression sur les couches de contact 53 et 56, en ménageant les ouvertures convenables dans la couche d'oxyde 95.

Lorsque les densités de courant à atteindre sont élevées, les raccordements des électrodes 53 et 56 pourront être renforcés par des dépôts métalliques localisés, réalisés dans des ouvertures de la couche d'oxyde. Ces dépôts en forme de boutons ou "bossages" 60 et 61 permettent d'améliorer l'opération de montage de la pièce, qui peut alors être effectuée soit par soudure, soit par compression, et conduit à une meilleure conduction thermique et électrique de la liaison.

Sur la figure 4, représentant le transistor multi-éléments vu en plan, on a fait figurer les régions de grille et de source avec leurs couches de contact respectives 56 et 53.

Le transistor multi-éléments de l'invention se développe selon deux axes perpendiculaires x o y, avec un degré d'extension lié au courant maximal recherché, soit en ajoutant des "barreaux" à la grille suivant o x, soit en allongeant ceux-ci suivant o y. Il est cependant opportun de rechercher le minimum de résistance de grille, de façon à ne pas ralentir le fonctionnement du dispositif en régime dynamique.

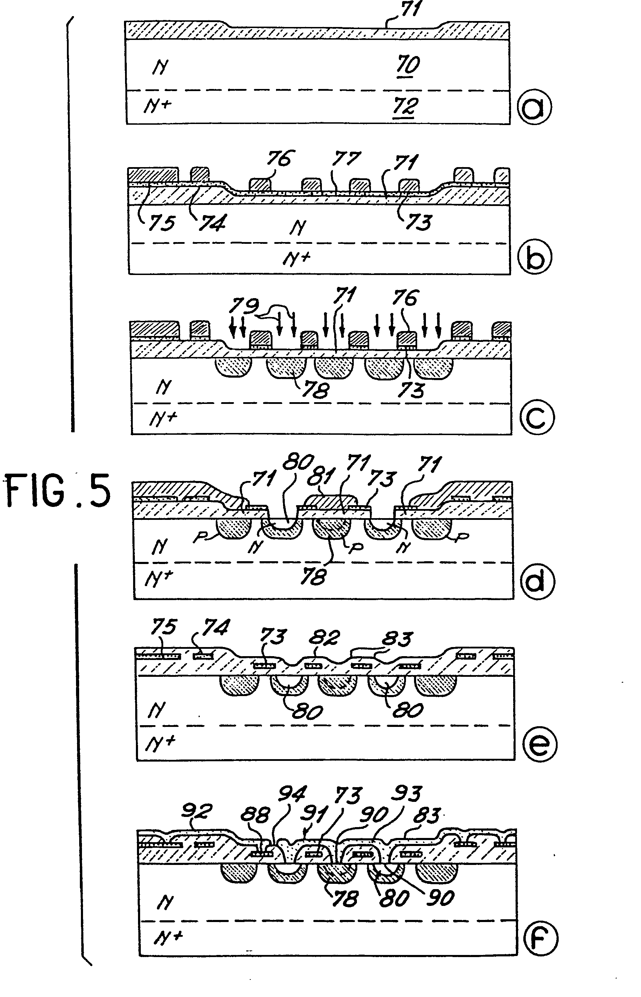

La figure 5 représente, suivant ses principales étapes référencées de (a) à (f), le procédé de fabrication d'un transistor vertical à canal diffusé multi-éléments selon l'invention.

12

A l'étape (a), une couche d'oxyde de silicium 71 est formée sur la couche 70, de type de conductivité N, déposée par croissance épitaxiale sur le substrat 72, dopé N +, qui constitue la région de contact du drain. Cette couche d'oxyde d'une épaisseur de l'ordre de 1500 Å, constitue la future couche d'isolement de grille. Elle peut être obtenue par oxydation thermique d'une ouverture ménagée dans une couche d'oxyde préalablement formée, et choisie d'une épaisseur plus grande (1 µ) pour protéger la périphérie du transistor.

A l'étape (b), une couche de silicium polycristallin 77 est déposée sur le substrat, et les électrodes de grille 73, d'écran 74 et les contre-électrodes 75, sont créées par attaque chimique à travers les ouvertures d'un masque de résine 76 ; ce silicium peut être préalablement dopé N +.

A l'étape (c) sont créées les régions de canal 78, de type P, par implantation de bore, suivant 79, à travers la couche d'oxyde 71, qui reste masquée par la couche de résine 76, subsistant de l'étape précédente, où elle avait servi à délimiter l'attaque chimique du silicium polycristallin.

La dose de bore implantée est de l'ordre de $4.10^{13}$ atomes par $cm^2$ ; un circuit ultérieur aboutit à une pénétration du bore à une profondeur de 2 à 3 µ.

C'est une caractéristique avantageuse du procédé que de permettre ainsi d'éviter toute contamination par le bore, de la couche d'oxyde située sous chaque grille 73.

C'est une autre caractéristique avantageuse que de réaliser ainsi des régions de formation de canal auto-alignées sur le bord des électrodes de grille 73, ainsi qu'à la périphérie du transistor, aux limites de la région d'oxyde de champ, dont l'épaisseur plus importante à cet endroit, de l'ordre de 1 µ, masque l'implantation.

A l'étape (d) sont créées les régions de source, par diffusion d'impuretée de type N, localisées par un nouveau masquage à la résine 81, qui est combiné avec l'effet de masque des grilles de silicium 73 pour s'opposer, en des zones déterminées du canal 78, à l'attaque préalable de la couche d'oxyde 71. Ces réserves d'oxyde permettent de masquer la diffusion N +, tout en conservant l'auto-alignement avec les bords des électrodes de grille des nouvelles régions de source 80. On peut choisir comme impureté N, de l'arsenic, de façon à obtenir une profondeur de diffusion faible, de l'ordre du micromètre, malgré l'importance des traitements thermiques nécessaires pour achever le dispositif.

Sur la figure 4, où le transistor multi-éléments de l'invention est vu en plan, on distingue clairement en AA' la coupe correspondant à la vue de la figure 5, où les parties coupées traversent alternativement les régions de source 80 et de formation de canal 78.

Dans les parties périphériques du transistor, où se trouve l'anneau de garde, on masque de la même manière la diffusion N +.

A l'étape (e) on dépose une nouvelle couche d'oxyde de silicium 82, qui recouvre complètement les

14

régions 73 de silicium polycristallin de grille, d'écran 74 et les contre-électrodes 75.

Cette couche peut être déposée en phase vapeur.

A l'étape (f) des ouvertures 90 ont été faites par masquage et photogravure dans la couche d'oxyde pour préparer les prises de contact avec les régions 78 et 80 de formation de canal et de source.

En vue d'adoucir les variations de relief de la couche 82, elle sera avantageusement dopée au phosphore, puis portée à température élevée, de l'ordre de 1050°C, pour subir le phénomène du fluage, et présenter ainsi des parties arrondies telles que 83, au bord des grilles 73 et des ouvertures 88 et 90.

La couche métallique 91 destinée à réaliser les contacts de grille 92 et de source 93, est alors déposée. Elle peut être obtenue, par exemple, par dépôt sous vide d'aluminium, dopé de préférence avec du silicum et du cuivre, de façon à limiter la pénétration de celui-ci dans les contacts.

Après séparation en deux couches de contact distinctes en 94. La couche 93 prend simultanément contact avec les régions de source 80 ou de formation de canal 78, et recouvre la totalité des éléctrodes de grille sous-jacentes 73, tout en restant isolée.

La surface importante qui en résulte permet de réaliser avantageusement des parties conductrices en relief telles que 60 et 61, ou "micro-bossages", visibles sur les figures 3 et 4, permettant d'améliorer la répartition du courant électrique et l'évacuation des calories.

Ces bossages peuvent être, par exemple, réalisés par croissance électrolytique d'or ou de cuivre, sur une couche de métal réfractaire déposé préalablement sur l'aluminium, couche assurant le double rôle d'électrode lors de l'électrolyse, et de barrière à l'interdiffusion des métaux en présence lors du fonctionnement du dispositif.

Il est à remarquer que le transistor de l'invention, bien qu'ayant été décrit dans le cas d'un mode de réalisation unitaire ou "discret", se prête aisément à l'intégration monolithique.

Dans ce cas, le mode de réalisation correspondant se combine, de façon avantageuse, avec celui des transistors bipolaires qui peuvent être présents dans le circuit intégré ; le contact de drain est alors pris sur la face "avant" du circuit, grâce à une diffusion profonde rejoignant le drain "enterré", de la même façon connue que pour les transistors bipolaires de type NPN.

Suivant des ordres de grandeur donnés à titre d'exemple, la disposition en deux plans superposés des électrodes de grille et de source a permis de réaliser des périmètres de source actifs par unité de surface très élevés, de $10^2$mm par mm$^2$ de surface, en choisissant une distance de 20 μ comme "pas" des barreaux de grille.

Un tel périmètre de source actif permet d'obtenir des transistors présentant des transconductances de l'ordre de 1,3 par mm$^2$, soit des courants de

16

saturation de 6 A par $mm^2$ pour des tensions de commande de 10 V sur la grille.

En régime de saturation, la vitesse limite étant atteinte dans la plus grande partie du dispositif, et les capacités parasites entre l'électrode de grille et les régions de source et de drain étant réduites par l'auto-alignement de ces régions, des fréquences de transition de l'ordre de 1 GHz ont été obtenues, pour des éléments dont la tenue en tension atteint 100 V.

Dans le cas d'un mode de réalisation pour mise en oeuvre dans un circuit intégré, les données technologiques particulières correspondantes, telles que le "drain enterré", et la reprise du contact de drain dans le même plan que la source, quoique provoquant une certaine réduction des performances intrinsèques, fournissent cependant des transistors verticaux multi-éléments présentant des avantages décisifs sur les transistors bipolaires équivalents.

17

REVENDICATIONS

1. Transistor à effet de champ vertical de puissance pour hautes fréquences, comprenant, dans un substrat de silicium, d'un premier type de conductivité, avec deux faces principales respectivement avant et arrière, une région de drain (8) de même type de conductivité débouchant sur la face arrière, deux régions de source (22) (23), de même type de conductivité fortement dopé, respectivement incluses dans deux régions de formation de canal (24) (25), de type de conductivité P, débouchant sur la face avant, cette face étant recouverte d'une couche (30) d'oxyde de silicium, et une grille (26) entièrement incluse dans cette couche, et disposée entre les deux régions de source, transistor caractérisé en ce que les connexions reliant les deux régions de source sont constituées par une couche conductrice (31) déposée sur la couche d'oxyde de silicium.

2. Transistor selon la revendication 1, caractérisé en ce que la grille est constituée de silicium polycristallin, contenant une impureté de dopage.

3. Transistor selon la revendication 1, caractérisé en ce que la grille est constituée de Molybdène, ou de Tungstène.

4. Transistor selon la revendication 1, caractérisé en ce que la grille est constituée d'un matériau comprenant du silicium combiné avec du Molybdène ou du Tungstène.

18

5. Transistor selon la revendication 1, caractérisé en ce que la couche conductrice est constituée d'un matériau comprenant l'aluminium.

6. Transistor selon la revendication 5, caractérisé en ce que la couche conductrice est constituée d'un matériau comprenant de plus du silicium et du cuivre.

7. Transistor selon l'une des revendications précédentes caractérisé en ce que la couche conductrice relie les deux régions de formation de canal aux deux régions de source.

8. Transistor multi-éléments, caractérisé en ce qu'il est constitué d'une pluralité de transistors selon l'une des revendications précédentes, disposés parallèlement aux faces principales, avec leurs connexions de source et de grille reliées respectivement en parallèle.

9. Transistor multi-éléments selon la revendication 8, caractérisé en ce qu'il comporte, sur sa face avant, une région dopée du second type de conductivité, formant anneau de garde, l'entourant complètement et une électrode d'écran constituée de silicium polycristallin.

10. Procédé de réalisation d'un transistor selon l'une des revendications précédentes, caractérisé en ce qu'il comporte les étapes suivantes, effectuées sur un substrat de silicium du premier type de conductivité, avec deux faces principales avant et arrière, une région du même type de conductivité fortement dopée débouchant sur la face arrière :

- Formation d'une couche d'oxyde de silicium sur la face avant, d'une épaisseur de l'ordre de 1500 $\overset{o}{A}$ ;

- Dépôt sur la couche d'oxyde d'une couche de silicium polycristallin, et formation, par attaque chimique de celui-ci à travers les ouvertures d'un masque de résine photosensible, des électrodes de grille et d'écran, et d'un anneau de garde ;

- Formation des régions de formation de canal, à travers les ouvertures du masque précédent , par implantation ionique, d'une impureté du second type, réalisant l'auto-alignement de ces régions par rapport à la grille qui les contrôle, implantation suivie d'une diffusion des impuretés par chauffage ;

- Formation des régions de source, par diffusion d'une impureté du premier, à travers les ouvertures d'un nouveau masque de résine photosensible ;

- Formation d'une nouvelle couche d'oxyde de silicium sur l'ensemble de la face avant ;

- Réalisation d'ouvertures dans cette nouvelle couche, et dépôt d'une couche métallique conductrice en deux zones sur l'ensemble de la face avant, en contact électrique, par les ouvertures, d'une part avec la grille, d'autre part avec les sources et les régions de formation de canal.

- Réalisation de bossages métalliques en saillie sur les deux zones pour prise de contacts électriques.

11. Procédé de réalisation d'un transistor selon la revendication 10, caractérisé en ce que

20

l'impureté est du bore, pour une région de formation de canal de type P.

12. Procédé de réalisation d'un transistor selon l'une des revendications 10 ou 11, caractérisé en ce que l'impureté de type N est de l'arsenic.

FIG.1

FIG.2

FIG. 3  (COUPE AA')

FIG. 4

FIG.5

**Office européen des brevets**

## RAPPORT DE RECHERCHE EUROPEENNE

EP 80 40 0907

| | DOCUMENTS CONSIDERES COMME PERTINENTS | | CLASSEMENT DE LA DEMANDE (Int. Cl. 3) |
|---|---|---|---|
| Catégorie | Citation du document avec indication, en cas de besoin, des parties pertinentes | Revendica-tion concernée | |
| | FR - A - 2 400 259 (HITACHI)<br>* Page 18, lignes 2-27;<br>page 19, lignes 12-31; figures<br>12-15; 19 *<br><br>--<br><br>US - A - 4 145 700 (IBM)<br>* "Abstract"; figure 9A<br><br>---- | 1,2,5<br><br><br><br><br>1 | H 01 L 29/78<br>29/60<br>29/10 |

**DOMAINES TECHNIQUES RECHERCHES (Int. Cl. 3)**

H 01 L 29/78
29/60
29/10

**CATEGORIE DES DOCUMENTS CITES**

X: particulièrement pertinent
A: arrière-plan technologique
O: divulgation non-écrite
P: document intercalaire
T: théorie ou principe à la base de l'invention
E: demande faisant interférence
D: document cité dans la demande
L: document cité pour d'autres raisons

&: membre de la même famille, document correspondant

Le présent rapport de recherche a été établi pour toutes les revendications

| Lieu de la recherche | Date d'achèvement de la recherche | Examinateur |
|---|---|---|
| La Haye | 29-09-1980 | PELSERS |

OEB Form 1503.1  06.78